(19) Europäisches Patentamt
European Patent Office
Office européen des brevets

(11) **EP 2 740 152 B1**

(12) **FASCICULE DE BREVET EUROPEEN**

(45) Date de publication et mention
de la délivrance du brevet:
**17.05.2017 Bulletin 2017/20**

(21) Numéro de dépôt: **12758523.0**

(22) Date de dépôt: **27.07.2012**

(51) Int Cl.:
*H01L 23/38* (2006.01)          *H01L 23/34* (2006.01)
*G01K 1/14* (2006.01)          *G01K 7/42* (2006.01)
*G01K 3/14* (2006.01)

(86) Numéro de dépôt international:
**PCT/FR2012/000316**

(87) Numéro de publication internationale:
**WO 2013/017748 (07.02.2013 Gazette 2013/06)**

(54) **DISPOSITIF DE LOCALISATION DE POINTS CHAUDS AVEC DES FLUXMÈTRES THERMIQUES**

VORRICHTUNG ZUR LOKALISIERUNG VON HOT SPOTS MIT WÄRMEDURCHFLUSSMESSER

DEVICE FOR LOCALIZING HOT SPOTS WITH HEAT FLOW METERS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **01.08.2011 FR 1102407**

(43) Date de publication de la demande:
**11.06.2014 Bulletin 2014/24**

(73) Titulaire: **Commissariat à l'Énergie Atomique
et aux Énergies Alternatives
75015 Paris (FR)**

(72) Inventeurs:
• **CAROFF, Tristan
F-38610 Gières (FR)**
• **REMONDIERE, Vincent
F-38120 Saint Egrève (FR)**

(74) Mandataire: **Talbot, Alexandre et al
Cabinet Hecké
Europole
10, rue d'Arménie - BP 1537
38025 Grenoble Cedex 1 (FR)**

(56) Documents cités:
EP-A2- 1 443 568          DE-A1- 10 132 763
US-A1- 2007 296 071          US-A1- 2009 288 425
US-A1- 2009 312 887

## Description

### Domaine technique de l'invention

L'invention concerne un dispositif comportant une zone d'intérêt disposée sur une surface d'un substrat et un système de détection de points chauds situés dans ladite zone d'intérêt.

### État de la technique

Avec l'augmentation de la densité d'intégration, la puissance électrique dissipée au sein des dispositifs électroniques ne cesse de croître. L'augmentation de la puissance électrique dissipée peut générer un phénomène dit d'auto-échauffement. Un tel phénomène peut engendrer la dégradation de certaines caractéristiques physiques et électriques des dispositifs électroniques.

Actuellement, les circuits électroniques comportent de plus en plus de systèmes de gestion de la puissance thermique. Lorsque la température au sein du circuit électronique dépasse un certain seuil, le système de gestion de la puissance thermique peut, par exemple, déclencher un ventilateur ou suspendre l'activité de certains composants ou circuits annexes. L'efficacité de ce type de système dépend de l'information recueillie, par une sonde thermique, sur l'état d'échauffement du circuit électronique. La sonde thermique est placée, généralement, à proximité du circuit électronique et est reliée au système de gestion de la puissance thermique.

Pour une efficacité optimum, la sonde thermique est disposée au plus près des composants critiques susceptibles de subir une surchauffe. Ainsi, la sonde thermique est, généralement, invasive c'est-à-dire qu'elle est réalisée à l'intérieur même de la zone d'intérêt sondée qui comporte les composants électroniques critiques. Les règles d'intégration deviennent alors, de plus en plus contraignantes. En particulier dans le cas d'une sonde thermique de type diode, la circulation du courant dans la diode peut perturber le fonctionnement du composant électronique sondé.

La demande de brevet US 2007/0296071 décrit un boîtier d'encapsulation muni de sondes thermiques destinées à détecter un point chaud dans un circuit électronique encapsulé. Généralement, les boîtiers d'encapsulation sont réalisés dans un substrat différent du substrat comportant le circuit électronique. Par conséquent, ce type de sondes thermiques est réalisé suivant des procédés spécifiques, compliquant davantage leur fabrication. De plus, les sondes thermiques, dans cette demande de brevet, sont placées sous le circuit électronique. Cet agencement des sondes thermiques est difficilement réalisable puisqu'il dépend de plusieurs facteurs tels que la surface disponible du substrat du boîtier et la disposition des connexions électriques reliant les sondes thermiques et le circuit de gestion de la puissance thermique. Par ailleurs, un tel dispositif a une zone d'observation très réduite, et il est incapable de détecter un point chaud difficile d'accès. Par ailleurs, la demande de brevet US 2009/288425 divulgue un dispositif de régulation du comportement thermique d'un circuit intégré lors de l'apparition de points chauds. Le circuit intégré à surveiller est réalisé sur un premier substrat, alors que le dispositif de régulation thermique est réalisé sur un deuxième substrat rapporté en face arrière du premier substrat. Le dispositif de régulation comporte une pluralité de dispositifs thermoélectriques distribués dans le second substrat de manière à former un quadrillage. Chaque dispositif thermoélectrique comporte une thermistance pour évaluer la température dans une partie du circuit intégré disposé dans le premier substrat. La réalisation de ce type de dispositif de régulation thermique devient alors compliquée.

La demande de brevet US 2009/312887 décrit un dispositif de stabilisation thermique d'un composant électronique assemblé sur un substrat PCB. Le dispositif de stabilisation thermique comporte une matrice de dispositifs thermosensibles, une matrice de dispositifs thermoélectriques et un contrôleur de type MIMO (MIMO pour l'abréviation anglaise de « Multiple-Input, Multiple-Output »). Une pâte thermo-conductrice est interposée entre ledit composant électronique et le substrat PCB. Par ailleurs, le dispositif de stabilisation thermique comporte un dispositif thermoélectrique disposé au-dessus du composant électronique.

### Objet de l'invention

Dans certaines applications utilisant des dispositifs électroniques réalisés avec une importante densité d'intégration sur une surface d'un substrat, il existe un besoin de mise en oeuvre d'un système non invasif, fiable et facile à réaliser, permettant de localiser et de quantifier la température d'un point chaud qui apparaît dans cette surface du substrat.

On tend à satisfaire ce besoin en prévoyant un dispositif électronique comportant un substrat muni d'une surface qui comporte une zone d'intérêt dont le comportement thermique est à surveiller, un système de détection de points chauds situés dans ladite zone d'intérêt. Le système de détection comporte une unité de calcul et au moins trois fluxmètres thermiques distincts disposés sur la surface du substrat à l'extérieur de la zone d'intérêt.

## Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- la figure 1 représente, schématiquement et en perspective, un dispositif électronique selon un premier mode de réalisation particulier de l'invention ;
- la figure 2 représente, schématiquement et en vue de dessus, un exemple de fluxmètre thermique utilisé par le dispositif électronique de la figure 1 ;
- la figure 3 représente, schématiquement et en coupe, un mode de réalisation particulier de l'invention utilisant des moyens de refroidissement ;
- les figures 4 à 7 représentent, schématiquement et en perspective, un dispositif électronique selon d'autres modes de réalisation particuliers de l'invention ;
- la figure 8 représente, schématiquement et en vue de dessus, trois points chauds distincts disposés au voisinage du fluxmètre thermique de la figure 2 ;
- les figures 9 et 10 représentent, schématiquement et en vue de dessus, un dispositif électronique selon d'autres modes de réalisation particuliers de l'invention.

## Description de modes particuliers de réalisation

Un moyen fiable et pratique pour la détection de points chauds dans une zone d'intérêt d'une surface d'un substrat, consiste à utiliser un système à base de fluxmètres thermiques. Plus particulièrement, le système de détection de points chauds est un système non invasif qui comporte des fluxmètres thermiques disposés à l'extérieur de la zone d'intérêt dont le comportement thermique est à surveiller.

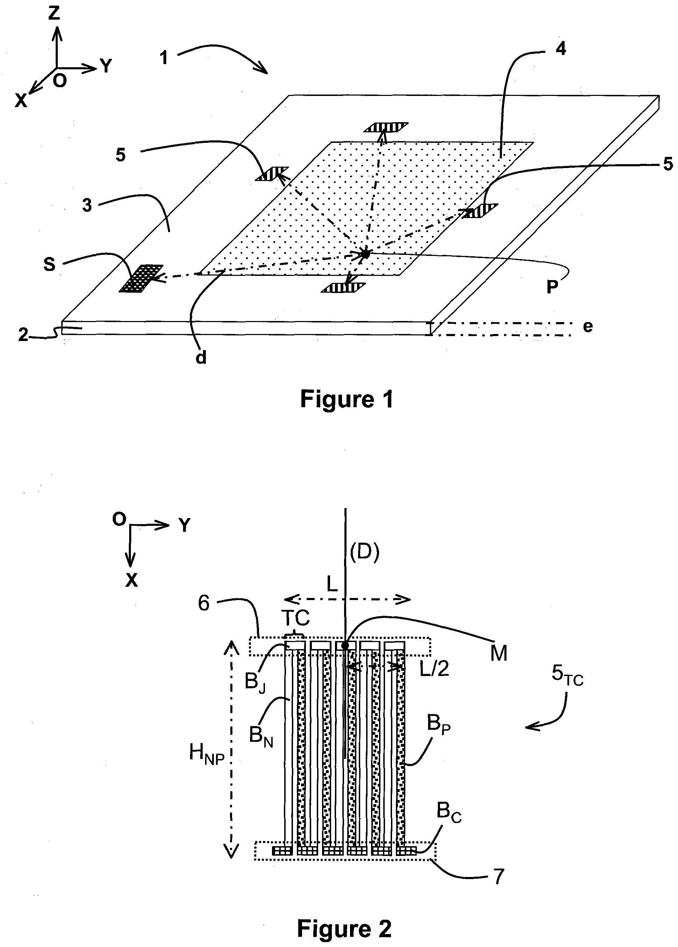

Selon un mode particulier de réalisation, un dispositif électronique 1 est représenté à la figure 1. Le dispositif électronique 1 comporte un substrat 2, ayant préférentiellement une épaisseur e. Le substrat 2 est muni d'une surface 3, de préférence sensiblement plane, et comprenant une zone d'intérêt 4 dont le comportement thermique est à surveiller.

La zone d'intérêt 4 du substrat 2 peut, par exemple, comporter un ou plusieurs composants électroniques actifs ou passifs réalisés sur la face avant du substrat 2, autrement dit sur la surface 3. Ces composants, en dissipant une certaine puissance électrique peuvent générer une élévation de la température dans la zone d'intérêt créant ainsi un point chaud. Par « surveiller » on entend détecter d'éventuelles anomalies thermiques, et plus particulièrement des points chauds qui peuvent se manifester. Pour cela, le dispositif électronique 1 comporte un système de détection de points chauds situés dans la zone d'intérêt 4.

Le système de détection de points chauds comporte au moins trois fluxmètres thermiques 5 distincts disposés sur la surface 3 du substrat 2, à l'extérieur de la zone d'intérêt 4. Par « fluxmètre thermique », on entend un dispositif sensible à un gradient de température, et destiné à mesurer des valeurs représentatives d'un flux thermique généré par ce gradient de température. Grâce à ces fluxmètres thermiques 5, il est possible de déterminer l'emplacement d'un point chaud P dans la zone d'intérêt 4 ou encore la puissance thermique et la température dudit point chaud P.

Le flux thermique généré par un point chaud P est propagé dans le substrat 2, et il atteint les différents fluxmètres thermiques 5 plus ou moins proches du point chaud P. Chaque fluxmètre thermique 5 génère une réponse, préférentiellement électrique, au flux thermique l'atteignant qui dépend notamment de la distance le séparant du point chaud P.

En calibrant préalablement les fluxmètres thermiques 5 et en utilisant leurs réponses, il est possible de localiser un ou plusieurs points chauds pouvant se manifester dans la zone d'intérêt 4. En effet, à l'aide d'algorithmes mathématiques simples, par exemple ceux qui utilisent le principe de la triangulation, la localisation de points chauds dans la zone d'intérêt 4 peut être réalisée en exploitant les réponses des fluxmètres thermiques 5. Dès lors, le système de détection comporte avantageusement une unité de calcul programmé pour analyser les valeurs des différents fluxmètres thermiques afin de déterminer préférentiellement par triangulation, l'emplacement, la puissance thermique et la température d'un point chaud de la zone d'intérêt 4. Préférentiellement, la zone d'intérêt 4, les fluxmètres thermiques 5 et l'unité de calcul sont réalisés sur la surface 3 du substrat 2. Cette configuration permet avantageusement d'éviter les problèmes d'alignement. En effet, et à titre d'exemple, des problèmes d'alignement peuvent survenir lorsque des éléments du système de détection et la zone d'intérêt sont réalisés sur deux différents substrats collés. En outre, une solidarisation de ces deux substrats peut être à l'origine d'un problème de fiabilité lié à la tenue du collage dans le temps, engendrant ainsi, une dégradation des performances thermiques du dispositif.

Comme indiqué ci-dessus, le système de détection de points chauds peut déterminer la puissance thermique du point chaud P. La notion de puissance thermique est intimement liée à celle du flux thermique. En effet, la puissance thermique à travers une surface isotherme donnée est, par définition, la somme de la densité de flux thermiques à travers ladite surface isotherme. De ce fait, la puissance thermique du point chaud P, dissipée au sein de la zone d'intérêt 4, peut être déterminée par corrélation avec la somme des réponses provenant des fluxmètres thermiques 5 suivant la

relation : $\Phi = k \times \sum_{1}^{N} \Delta V$ . Avec $\Phi$ la puissance thermique dissipée dans la zone d'intérêt 4, N le nombre de fluxmètres

thermiques 5, $\Delta V$ la réponse de chaque fluxmètre thermique 5 et k une constante déterminée en fonction de l'agencement des fluxmètres thermiques 5 par rapport à la zone d'intérêt 4, et en fonction des propriétés physiques des fluxmètres thermiques 5. La constante k peut être déterminée par calcul ou par calibration.

La température du point chaud P de la zone d'intérêt 4 peut être déterminée en utilisant une sonde de température de référence S disposée au niveau du substrat 2 en dehors de la zone d'intérêt 4 pour ne pas être invasive. Par exemple, la température du point chaud P peut être calculée en combinant, notamment, les valeurs de températures mesurées par ladite sonde de température de référence S, la puissance thermique $\Phi$ du point chaud déterminée à partir des fluxmètres thermiques 5, la distance d séparant la sonde de température de référence S du point chaud P. La température $T_C$ du point chaud P peut être déterminée, par exemple, par la relation suivante : $T_C = T_{ref} + \Phi$ x $R_{SP}$. Avec $R_{SP}$ la résistance thermique de la partie du substrat séparant le point chaud P de la sonde de température de référence S.

Le système de détection de points chauds du dispositif 1 peut utiliser des fluxmètres thermiques de tout type connu. À titre d'exemple, un fluxmètre thermique 5 peut comporter des première et deuxième sondes de température adjacentes, disposées sur un substrat, par exemple le substrat 2, dont la résistance thermique $R_{th-s}$ est connue. Cette disposition permet de déterminer le flux thermique traversant ledit substrat entre les deux sondes thermiques. En effet, le flux thermique $\varphi$ peut être déterminé par la relation suivante :

$$\varphi = (T_{S1} - T_{S2}) \text{ x } R_{th-s} \qquad (1)$$

Avec, $T_{S1}$ et $T_{S2}$ les températures mesurées par, respectivement la première et deuxième sonde de température. Cependant, ce type de fluxmètre thermique requiert une connectique complexe.

Afin de faciliter la connectique et le traitement des réponses par l'unité de calcul programmée, les fluxmètres thermiques 5 sont, de préférence, des fluxmètres thermoélectriques qui permettent de convertir une énergie thermique en énergie électrique grâce à l'effet « Seebeck ». Les fluxmètres thermiques 5, peuvent comporter, par exemple, des thermocouples planaires. Par « thermocouple planaire », on entend un thermocouple comportant des barreaux réalisés parallèlement au plan d'un substrat. Ce substrat est préférentiellement, le substrat 2 portant la zone d'intérêt 4. Le flux thermique à détecter se déplace dans le plan du substrat 2 comportant les thermocouples, et il se propage quasi exclusivement dans le substrat 2. De ce fait, afin d'optimiser et de calibrer ce type de fluxmètres thermiques, les résistances et capacités thermiques à prendre en considération sont principalement celles du substrat 2.

Un exemple d'un fluxmètre thermoélectrique $5_{TC}$ est représenté à la figure 2. Le fluxmètre thermique $5_{TC}$ peut comporter m thermocouples TC avec m un nombre entier le plus grand possible. Afin d'améliorer la sensibilité du fluxmètre thermoélectrique, le nombre m de thermocouples est limité par la surface disponible et par la résolution de la technologie utilisée pour leur fabrication. Actuellement, on trouve communément des fluxmètres thermoélectriques comportant 6 à 20 barreaux de 20 à 40 $\mu$m de longueur et moins de 100 nm d'épaisseur. Dans le cas représenté à la figure 2, le fluxmètre thermique $5_{TC}$ comporte 5 thermocouples TC qui peuvent être alignés les uns à côté des autres, de manière à être connectés électriquement en série via l'interconnexion $B_C$. Généralement, les fluxmètres thermoélectriques comportent plusieurs thermocouples connectés électriquement en série, et disposés thermiquement en parallèle par rapport au flux thermique à détecter de sorte à obtenir une réponse électrique efficace du fluxmètre thermique. Chaque thermocouple TC est, de préférence, en forme de U, et il comporte deux barreaux $B_N$ et $B_P$ sensiblement parallèles. Autrement dit, il est préférable que chaque fluxmètre thermique $5_{TC}$ du système de détection de points chauds comporte au moins un thermocouple TC muni de deux barreaux $B_N$ et $B_P$ en matériaux thermoélectriques.

Les barreaux $B_N$ et $B_P$ d'un thermocouple TC donné, sont reliés entre eux au niveau d'une de leur extrémité par un élément $B_J$, de manière à former une jonction thermoélectrique. Autrement dit, le fluxmètre thermoélectrique $5_{TC}$ comporte m barreaux $B_N$ et m barreaux $B_P$, sensiblement parallèles et disposés en alternance : un barreau $B_N$ à côté d'un barreau $B_P$. Les barreaux $B_N$ et $B_P$ ont une hauteur $H_{NP}$. Les barreaux $B_N$ et $B_P$ sont également reliés entre eux via l'élément $B_C$ pour connecter électriquement deux thermocouples TC adjacents.

Les barreaux $B_N$ et $B_P$ sont formés à base de matériaux de natures thermoélectriques différentes, c'est-à-dire des matériaux aptes à générer l'effet Seebeck. De préférence, les barreaux $B_N$ et $B_P$ sont dopés, respectivement, N et P. En effet, l'association de deux matériaux thermoélectriques différents dopés N et P permet d'augmenter le coefficient Seebeck différentiel entre les deux matériaux. Ainsi, la sensibilité du thermocouple TC est améliorée.

Les barreaux $B_N$ et $B_P$ peuvent être réalisés par tout procédé connu, par exemple, à l'aide d'un procédé d'impression tel que le jet d'encre ou la sérigraphie qui présentent un avantage en termes de coût de fabrication. Les thermocouples TC peuvent être, également, réalisés par un procédé de dépôt de couches minces utilisées dans le domaine de la microélectronique, tel que le dépôt chimique en phase vapeur noté CVD ou encore le dépôt par pulvérisation noté PVD. À titre d'exemple, une étape d'implantation ionique, peut être également utilisée, après l'étape de dépôt, pour doper les barreaux $B_N$ et $B_P$ afin d'améliorer la sensibilité à un gradient de température du thermocouple TC.

En fonctionnement, le fluxmètre thermique $5_{TC}$ est disposé dans un gradient de température. De préférence, une extrémité des thermocouples TC est située au niveau d'un premier côté 6, ou « côté chaud », agencé à proximité d'une première source, par exemple une source de chaleur et l'autre extrémité des thermocouples TC est, de ce fait, située au niveau d'un second côté 7, ou « côté froid », éloigné de la source de chaleur. Dans le cas présent, la source de chaleur est constituée par les points chauds de la zone d'intérêt 4. Ainsi, pour augmenter la sensibilité du fluxmètre thermique $5_{TC}$, il est préférable que le « côté chaud » 6 soit disposé au plus près de la zone d'intérêt 4 dont le comportement thermique est à surveiller. Pour le fluxmètre thermique $5_{TC}$ de la figure 2, l'élément $B_J$ forme le « côté chaud » 6 et $B_C$ forme le «côté froid » 7. De préférence, les barreaux $B_N$ et $B_P$ du thermocouple TC disposent de première et seconde extrémités. La première extrémité est proximale de la zone d'intérêt 4. La seconde extrémité des barreaux $B_N$ et $B_P$ est distale de la zone d'intérêt 4.

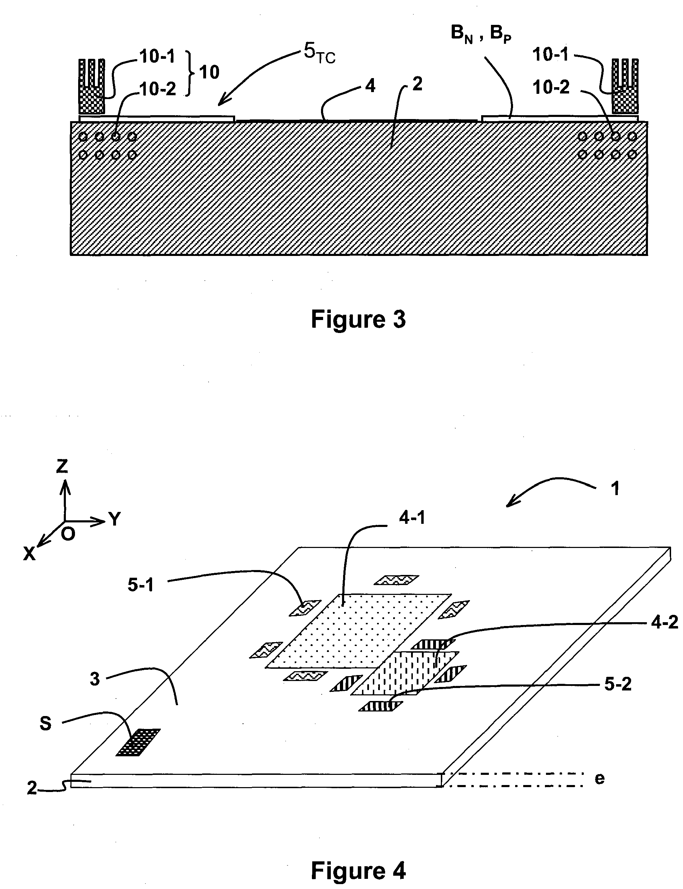

Selon un mode de réalisation illustré à la figure 3, des moyens de refroidissement 10 sont associés au fluxmètre thermique $5_{TC}$ du même type que celui représenté à la figure 2. Les moyens de refroidissement 10, sont disposés au niveau de la seconde extrémité des barreaux $B_N$ et $B_P$. Les moyens de refroidissement 10 peuvent comporter des radiateurs miniatures 10-1 et/ou des micro-caloducs 10-2 destinés à faire circuler un fluide de refroidissement. Les radiateurs miniatures 10-1 sont, préférentiellement, disposés sur l'extrémité des barreaux $B_N$ et $B_P$ au niveau de la seconde extrémité. Les micro-caloducs 10-2 peuvent être formés dans le substrat 2. De préférence, les micro-caloducs 10-2 sont formés sous la seconde extrémité des barreaux $B_N$ et $B_P$. Les moyens de refroidissement permettent de diminuer la température de l'extrémité des thermocouples TC situés au niveau de la seconde extrémité distale de la zone d'intérêt 4. Dès lors, les moyens de refroidissement permettent, avantageusement, d'augmenter la différence de température entre la première extrémité et la seconde extrémité des barreaux $B_N$ et $B_P$ et ainsi d'améliorer la sensibilité du fluxmètre thermoélectrique $5_{TC}$.

Selon une variante de réalisation représentée à la figure 4, la zone d'intérêt 4 comporte une première région 4-1 et une deuxième région 4-2. Comme représenté à la figure 4, un premier ensemble d'au moins trois fluxmètres thermiques 5-1 est disposé sur la surface 3 du substrat 2 à l'extérieur de la première région 4-1 pour la détection de points chauds dans la première région 4-1. Un deuxième ensemble d'au moins trois fluxmètres thermiques 5-2 est, également, disposé sur la surface 3 du substrat 2 à l'extérieur de la deuxième région 4-2 pour la détection de points chauds dans la deuxième région 4-2. Le système de détection de points chauds dans la zone d'intérêt 4 comporte, selon cette variante de réalisation, les premier et deuxième ensembles de fluxmètres thermiques 5-1 et 5-2. Cet agencement des fluxmètres thermiques 5-1 et 5-2 permet, avantageusement, de distribuer les fluxmètres thermiques 5-1 et 5-2 de manière à mieux couvrir la zone d'intérêt 4 en fonction de sa forme géométrique.

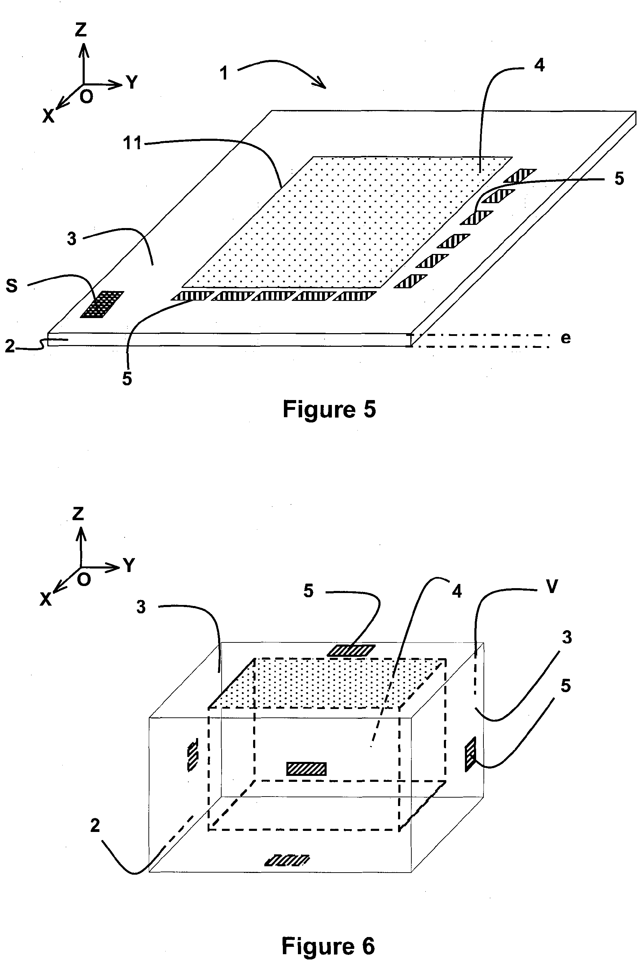

Selon un mode particulier de réalisation illustré à la figure 5, la zone d'intérêt 4 a une forme rectangulaire 11 et les fluxmètres thermiques 5 sont disposés le long d'un côté du rectangle 11. De préférence, les fluxmètres thermiques 5 sont échelonnés le long d'au moins deux côtés perpendiculaires du rectangle 11. Autrement dit, les fluxmètres thermiques 5 sont répartis selon deux axes perpendiculaires formant deux côtés adjacents d'un rectangle dans lequel la zone d'intérêt 4 est contenue. Afin de faciliter la connectique et leur mise en oeuvre, les fluxmètres thermiques 5 peuvent être reliés entre eux. Dans ce cas, les fluxmètres thermiques 5 délivrent des réponses différentielles qui sont ensuite transmises à l'unité de calcul du système de détection de point chaud. La résolution spatiale du système de détection de points chauds augmente avec l'augmentation du nombre de fluxmètres thermiques 5 disposés le long du côté du rectangle 11.

Selon un mode particulier de réalisation représenté à la figure 6, la surface 3 est une surface fermée comportant un volume V du substrat 2. La zone d'intérêt 4 est un volume compris dans le volume V. Au moins trois fluxmètres thermiques 5 sont disposés sur la surface 3 à l'extérieur de la zone d'intérêt 4. La zone d'intérêt 4 peut comporter des dispositifs et/ou des assemblages tridimensionnels de circuits électroniques. Ces circuits électroniques sont, préférentiellement, empilés et reliés par des vias et ils peuvent être réalisés suivant la technologie dite technologie « 3D-IC ». Cette technologie est de plus en plus utilisée puisqu'elle permet un degré d'intégration très élevé. Cependant cette technologie souffre de problèmes d'auto-échauffement. La disposition des fluxmètres thermiques 5 permet, avantageusement une gestion thermique de la zone d'intérêt 4 sans avoir besoin d'intégrer des sondes de température dans le volume de la zone d'intérêt 4. Ladite gestion thermique est réalisée en déterminant l'emplacement, la puissance thermique ou encore la température d'un point chaud de la zone d'intérêt 4.

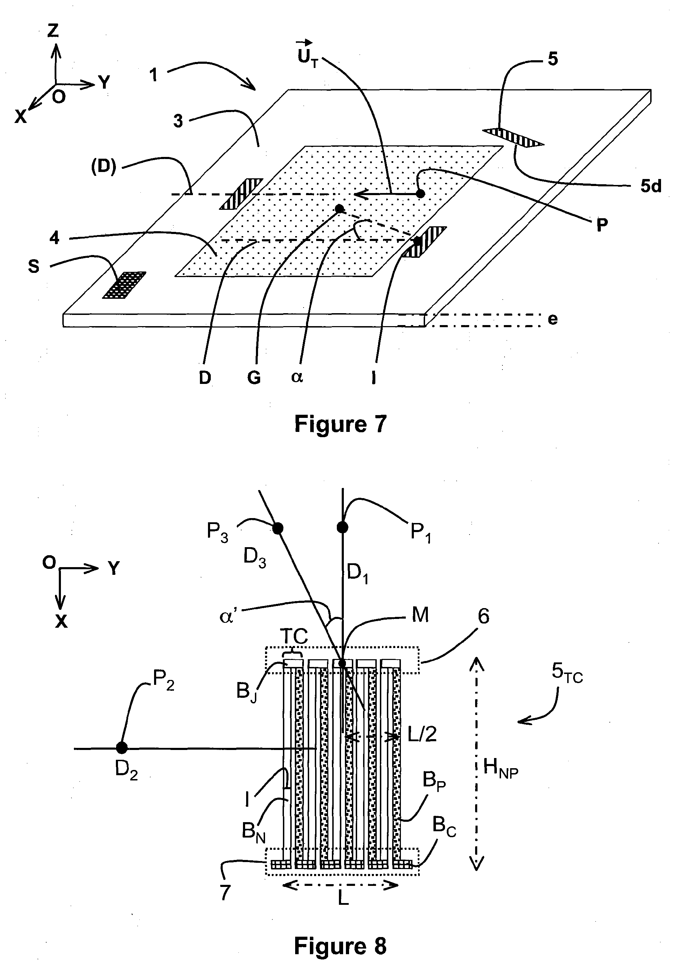

Selon un mode particulier de réalisation représenté à la figure 7, chaque fluxmètre thermique 5 comporte une face de détection 5d, avantageusement orientée vers l'isobarycentre G de la zone d'intérêt 4. Autrement dit, chaque fluxmètre thermique 5 comprend un axe de détection D, de préférence perpendiculaire à la face de détection 5d, et dont l'angle d'orientation $\alpha$, par rapport à une droite passant par l'isobarycentre G de la zone d'intérêt 4 et le fluxmètre thermique 5, est compris entre $-\pi/4$ et $\pi/4$, bornes incluses. Par « axe de détection » D d'un fluxmètre thermique 5, on entend la droite avec laquelle la direction du vecteur d'onde de chaleur $\vec{U}_T$ d'un point chaud P, doit être avantageusement confondue pour obtenir les meilleures précisions et sensibilités de détection du point chaud P par ce fluxmètre thermique 5.

À titre d'exemple, un fluxmètre thermique $5_{TC}$ du même type que celui représenté à la figure 2 peut être utilisé dans le mode de réalisation illustré à la figure 7. Il comporte alors des thermocouples TC identiques, échelonnés sur une longueur L et séparés l'un de l'autre avec une distance constante. L'axe de détection D de ce fluxmètre thermique 5, est la droite parallèle aux barreaux $B_N$ et $B_P$ et passant par le milieu M du fluxmètre thermique 5. Par « milieu du fluxmètre thermique » 5 on entend le point M situé à une distance d'environ L/2 des deux thermocouples situés, selon l'axe (oy), aux extrémités du fluxmètre thermique 5. Ainsi, la face de détection définie ci-dessus correspond en fait au côté chaud 6 de la figure 2.

On entend par angle d'orientation $\alpha$ l'angle aigu formé par l'axe de détection D et la droite passant par l'isobarycentre G de la zone d'intérêt 4 et le fluxmètre thermique 5, l'axe de détection D joignant en outre le fluxmètre thermique associé au niveau d'un point I d'intersection. Le fait d'avoir un angle d'orientation $\alpha$ compris entre $-\pi/4$ et $\pi/4$ pour tous les fluxmètres thermiques 5 permet, avantageusement, d'augmenter le nombre de fluxmètres thermiques 5 qui sont efficacement dirigés vers un point chaud donné de la zone d'intérêt 4. Dans ce cas, les réponses des fluxmètres thermiques 5 sont plus précises et sensibles. Une meilleure précision et sensibilité permettent d'améliorer la précision de localisation d'un point chaud P dans la zone d'intérêt 4.

À titre d'exemple illustré à la figure 8, trois points chauds $P_1$, $P_2$ et $P_3$ sont placés dans des positions différentes par rapport au fluxmètre thermique $5_{TC}$ représenté à la figure 2 et dont les mêmes références représentent les mêmes objets. Généralement, les barreaux formant un thermocouple ont une largeur I, typiquement de l'ordre de quelques $\mu$m, assez petite par rapport à leur hauteur $H_{NP}$, typiquement de l'ordre de dizaines voire centaines de $\mu$m.

Le point chaud $P_1$ est placé sur l'axe de détection $D_1$. Ainsi, toutes les extrémités des thermocouples disposées du « côté chaud » 6 sont situées sur les mêmes profils isothermes générés par le point chaud $P_1$. Dès lors, presque tous les thermocouples génèrent, sensiblement, le même signal électrique en réponse au flux thermique généré par le point chaud $P_1$. Les sensibilités et précisions du fluxmètre thermoélectrique 5 sont alors améliorées.

Le point chaud $P_2$ est placé sur un axe $D_2$ traversant le fluxmètre thermique 5. L'axe $D_2$ est également perpendiculaire aux barreaux $B_N$ et $B_P$. Les extrémités des barreaux $B_N$ et $B_P$, sont alors, situées sur les mêmes profils isothermes générés par le point chaud $P_2$. Ainsi, presque tous les thermocouples TC génèrent, sensiblement, un même signal électrique presque nul en réponse au flux thermique généré par le point chaud $P_2$.

Le point chaud $P_3$ est placé sur un axe $D_3$ traversant le fluxmètre thermique 5. L'axe $D_3$ forme avec l'axe $D_1$ un angle aigu $\alpha'$. Ainsi, les extrémités des thermocouples disposées du « côté chaud » 6 peuvent être situées sur des profils isothermes, générés par le point chaud $P_3$, légèrement différents. La hauteur $H_{NP}$ du thermocouple TC étant grande, la disposition du point chaud $P_3$ par rapport au fluxmètre thermique 5, peut générer de légères différences entre les réponses des thermocouples TC.

Il résulte de l'analyse ci-dessus, de la disposition des trois points chauds $P_1$, $P_2$ et $P_3$, qu'il existe un besoin d'adapter l'orientation des fluxmètres thermiques 5 de sorte à améliorer la détection de points chauds. Ce besoin peut être satisfait par une variante de réalisation, dans laquelle le système de détection de points chauds comporte des moyens de mise en rotation des fluxmètres thermiques 5 pour ajuster l'angle d'orientation $\alpha$ de l'axe de détection D. Chaque fluxmètre thermique 5 peut, par exemple, être muni d'un dispositif électromécanique destiné à imposer au fluxmètre thermique 5 associé un mouvement de mise en rotation de sorte à permettre à la face de détection du fluxmètre thermique de balayer la surface du substrat 2 au niveau de la zone d'intérêt 4. Ce mouvement de rotation permet, avantageusement, de faire pivoter les fluxmètres thermiques 5 autour de l'axe (oz) de manière à être mieux orientés vers un point chaud de la zone d'intérêt 4. Lesdits dispositifs électromécaniques interagissent, avantageusement, avec l'algorithme mathématique de l'unité de calcul qui exploite les réponses des fluxmètres thermiques de manière à trouver l'angle de rotation qui permet d'optimiser la sensibilité et la précision des fluxmètres thermiques 5. Typiquement, on considérera que, pour un fluxmètre thermique du type des figures 2 et 5, l'axe de détection passe par le point chaud lorsque la tension fournie par le fluxmètre thermoélectrique est maximale.

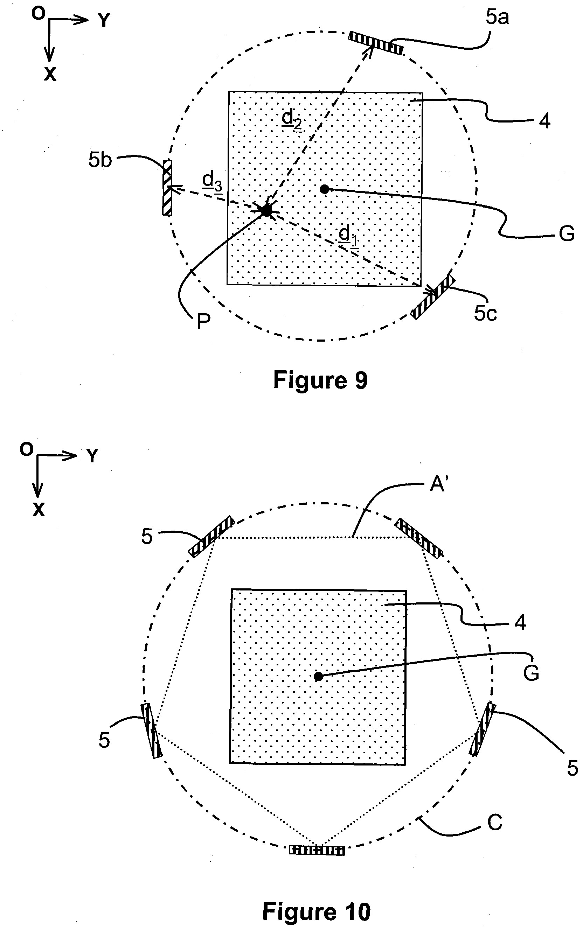

Selon un mode de réalisation particulier illustré à la figure 9, les fluxmètres thermiques 5a, 5b et 5c sont, avantageusement, situés à des distances sensiblement égales de l'isobarycentre G de la zone d'intérêt 4 dont le comportement thermique est à surveiller. Autrement dit, les fluxmètres thermiques 5 sont sensiblement disposés sur un cercle dont le centre coïncide avec l'isobarycentre G de la zone d'intérêt 4. Cet agencement des fluxmètres thermiques 5 permet de réduire la différence entre les distances $d_1$, $d_2$ et $d_3$ séparant un point chaud P quelconque de la zone d'intérêt 4, respectivement aux fluxmètres thermiques 5a , 5b et 5c. De ce fait, la réponse de chaque fluxmètre thermique 5 peut être exploitée avec des degrés de précision et de sensibilité comparables. Ainsi, l'algorithme mathématique utilisé par l'unité de calcul du système de détection de points chauds peut exploiter un nombre maximum de réponses précises des fluxmètres thermiques 5. Un calcul fiable des coordonnées d'un point chaud de la zone d'intérêt 4 et de la puissance thermique dudit point chaud est alors effectué.

Selon un mode de réalisation particulier illustré à la figure 10, cinq fluxmètres thermiques 5 sont agencés sous la forme d'un pentagone A' dont les sommets sont constitués par les cinq fluxmètres thermiques 5. Le pentagone A' est régulier et inscriptible dans un cercle C dont le centre coïncide avec l'isobarycentre G de la zone d'intérêt 4. Cette disposition permet d'uniformiser les angles et les longueurs des côtés du pentagone A'. Ainsi, de manière non limitative les fluxmètres thermiques 5 sont agencés, de préférence, sous la forme d'un polygone A' régulier et inscriptible dans un cercle C dont le centre coïncide avec l'isobarycentre G de la zone d'intérêt 4. Chaque sommet dudit polygone A' est associé à un fluxmètre thermique 5. Cet agencement permet de maximiser les angles entre les fluxmètres thermiques 5 et de répartir uniformément les fluxmètres thermiques 5 sur le cercle C. Ainsi, la zone d'intérêt 4 est mieux quadrillée selon ce mode de réalisation.

Selon un mode de réalisation particulier dans lequel les fluxmètres thermiques 5 sont des fluxmètres thermoélectriques du même type que celui représenté à la figure 2. Le système de détection comporte alors un système d'acquisition des signaux électriques des fluxmètres thermiques 5 de résolution de mesure $r_V$. Chaque fluxmètre thermique 5 comporte un nombre m de thermocouples TC, chaque thermocouple TC étant muni de deux barreaux $B_N$ et $B_P$ en matériau thermoélectrique ayant une hauteur $H_{NP}$.

Afin que le système de détection de points chauds fonctionne de manière optimale, il est préférable que les fluxmètres thermoélectriques $5_{TC}$ délivrent un signal électrique suffisant supérieur à la résolution $r_V$ d'un système d'acquisition des signaux électriques des fluxmètres thermoélectriques $5_{TC}$ du système de détection de points chauds dans la zone d'intérêt 4. Avantageusement, la sensibilité des fluxmètres thermoélectriques $5_{TC}$ est ajustée en tenant compte de la résolution électrique $r_V$, de la taille de la zone d'intérêt 4 à surveiller, et de la puissance minimale $\Phi_{min}$ d'un point chaud à détecter. En général, la résolution électrique $r_V$ a une valeur de l'ordre de 0,5 mV et la puissance thermique minimale $\Phi_{min}$ à détecter est de l'ordre de 10 mW.

Lors de la réalisation des fluxmètres thermoélectriques $5_{TC}$, la hauteur $H_{NP}$ et le nombre m des thermocouples TC constituent des paramètres, influençant la sensibilité, qui sont facilement ajustables. Avantageusement, on prendra en compte ces paramètres pour ajuster la sensibilité des fluxmètres thermoélectriques $5_{TC}$. La hauteur $H_{NP}$ des barreaux $B_N$ et $B_P$ des thermocouples TC est, avantageusement, définie par la formule :

$$H_{NP} \geq R \times \left( \exp\left( \frac{r_V \times 2\pi \times \lambda_{sub} \times e}{m \times S_{np} \times \Phi_{min}} \right) - 1 \right) \qquad (1)$$

Avec R le rayon du cercle circonscrit à la zone d'intérêt 4, $S_{np}$ le coefficient Seebeck différentiel des matériaux thermoélectriques desdits barreaux $B_N$ et $B_P$, $\lambda_{sub}$ la conductivité thermique du substrat 2, e l'épaisseur dudit substrat 2 et $\Phi_{min}$ la puissance thermique minimale à détecter, dissipée par un point chaud dans la zone d'intérêt 4. Dans ces conditions, la puissance dissipée $\Phi$ par un point chaud peut être déduite par la formule suivante $\Phi = k \times \sum_{1}^{N} \Delta V$.

Avec $\Phi$ la puissance thermique dissipée dans la zone d'intérêt 4, N le nombre de fluxmètres thermiques $5_{TC}$, $\Delta V$ la réponse de chaque fluxmètre thermique $5_{TC}$ et k une constante définie par la formule :

$$k = \frac{2\pi \times \lambda_{sub} \times e}{N \times m \times S_{np} \times \ln\left(1 + H_{np}/R\right)} \qquad (2)$$

Suivant une variante de réalisation, l'ajustement de la hauteur $H_{NP}$ des barreaux $B_N$ et $B_P$ peut dépendre également de l'angle d'orientation $\alpha$ du fluxmètre thermoélectrique $5_{TC}$. Avantageusement, pour un fluxmètre thermoélectrique $5_{TC}$ ayant un axe de détection D dont l'angle d'orientation $\alpha$, par rapport à une droite passant par l'isobarycentre G de la zone d'intérêt 4 et le fluxmètre thermoélectriques $5_{TC}$, est comprise entre $-\pi/4$ et $\pi/4$, bornes incluses, la hauteur $H_{NP}^{\alpha}$ des barreaux $B_N$, $B_P$ des thermocouples TC du fluxmètre thermoélectrique $5_{TC}$ est définie par la formule :

$$H_{NP}^{\alpha} \geq \frac{R}{\cos(\alpha)} \times \left( \exp\left( \frac{r_V \times 2\pi \times \lambda_{sub} \times e}{n \times S_{np} \times \Phi} \right) - 1 \right) \qquad (3)$$

Les variables utilisées sont les mêmes que celles définies ci-dessus.

**Revendications**

1. Dispositif électronique comportant :

   - un substrat (2) muni d'une surface (3) comportant une zone d'intérêt (4) comportant un ou plusieurs composants électroniques actifs ou passifs, et dont le comportement thermique est à surveiller ;
   - un système de détection de points chauds situés dans la zone d'intérêt (4) ;

   **caractérisé en ce que** le système de détection comporte :

   - au moins trois fluxmètres thermiques (5) sensibles à un gradient de température et destinés à mesurer des valeurs représentatives d'un flux thermique généré par un point chaud (P) dans la zone d'intérêt (4), les fluxmètres thermiques (5) étant distincts et disposés sur la surface (3) du substrat (2) à l'extérieur de la zone d'intérêt (4) ; et
   - une unité de calcul configurée pour analyser les valeurs des différents fluxmètres thermiques (5), et pour déterminer l'emplacement d'un point chaud (P) dans la zone d'intérêt (4).

2. Dispositif selon la revendication 1, **caractérisé en ce que** l'unité de calcul détermine l'emplacement d'un point chaud (P) dans la zone d'intérêt (4) par triangulation.

3. Dispositif selon l'une des revendications 1 et 2, **caractérisé en ce que** chaque fluxmètre thermique (5) comporte au moins un thermocouple (TC) planaire muni de deux barreaux ($B_N$, $B_P$) en matériaux thermoélectriques disposés parallèlement au plan du substrat (2).

4. Dispositif selon la revendication 3, **caractérisé en ce que** les fluxmètres thermiques (5) sont configurés pour détecter un flux thermique se déplaçant dans le plan du substrat (2) sur lequel les thermocouples (TC) sont formés.

5. Dispositif selon la revendication 3, **caractérisé en ce que** le fluxmètre thermique ($5_{TC}$) est disposé de manière à ce que le thermocouple (TC) comporte une première extrémité proximale de la zone d'intérêt (4), et une seconde extrémité distale de la zone d'intérêt (4).

6. Dispositif selon l'une des revendications 1 à 5, **caractérisé en ce que** :

   - chaque fluxmètre thermique (5) est muni d'un axe de détection (D) défini comme étant la droite avec laquelle la direction du vecteur d'onde de chaleur ($U_T$) d'un point (P) doit être confondue pour obtenir les meilleures précisions et sensibilités de détection du fluxmètre thermique (5) ; et **en ce que**
   - l'axe de détection (D) a un angle d'orientation $\alpha$, par rapport à une droite passant par l'isobarycentre (G) de la zone d'intérêt (4) et le fluxmètre thermique (5), compris entre $-\pi/4$ et $\pi/4$ radian, bornes incluses.

7. Dispositif selon la revendication 6, **caractérisé en ce que** le système de détection de points chauds comporte des moyens de mise en rotation des fluxmètres thermiques (5) pour ajuster l'angle d'orientation $\alpha$ de l'axe de détection (D).

8. Dispositif selon l'une quelconque des revendications 1 à 7, **caractérisé en ce que** les fluxmètres thermiques (5) sont situés à des distances sensiblement égales de l'isobarycentre (G) de la zone d'intérêt (4).

9. Dispositif selon l'une quelconque des revendications 1 à 8, **caractérisé en ce que** les fluxmètres thermiques (5) sont agencés sous la forme d'un polygone (A') dont chaque sommet est associé à un fluxmètre thermique (5), le polygone (A') étant régulier et inscriptible dans un cercle (C) dont le centre coïncide avec l'isobarycentre (G) de la zone d'intérêt (4).

10. Dispositif selon l'une quelconque des revendications 1 à 7, **caractérisé en ce que** les fluxmètres thermiques (5) sont répartis selon deux axes perpendiculaires formant deux côtés adjacents d'un rectangle dans lequel la zone d'intérêt (4) est contenue.

11. Dispositif selon l'une quelconque des revendications 1 à 9, **caractérisé en ce que** le système de détection de points chauds dans la zone d'intérêt (4) comporte un système d'acquisition des signaux électriques des fluxmètres thermiques ($5_{TC}$) de résolution de mesure $r_V$, et **en ce que** chaque fluxmètre thermique ($5_{TC}$) comporte un nombre m de thermocouples, chaque thermocouple étant muni de deux barreaux ($B_N$, $B_P$) en matériaux thermoélectriques dont la hauteur $H_{NP}$ est définie par la formule :

$$H_{NP} \geq R \times \left( \exp\left( \frac{r_V \times 2\pi \times \lambda_{sub} \times e}{m \times S_{np} \times \Phi_{min}} \right) - 1 \right)$$

avec R le rayon du cercle circonscrit à la zone d'intérêt (4), $S_{np}$ le coefficient Seebeck différentiel des matériaux thermoélectriques desdits barreaux ($B_N$, $B_P$), $\lambda_{sub}$ la conductivité thermique du substrat (2), e l'épaisseur dudit substrat (2) et $\Phi_{min}$ la puissance thermique minimale à détecter, dissipée par le point chaud dans la zone d'intérêt (4).

12. Dispositif selon la revendication 6, **caractérisé en ce que** le système de détection de points chauds dans la zone d'intérêt (4) comporte un système d'acquisition des signaux électriques des fluxmètres thermiques (5) de résolution de mesure $r_V$, et **en ce que** chaque fluxmètre thermique (5) comporte un nombre m de thermocouples, chaque thermocouple étant muni de deux barreaux ($B_N$, $B_P$) en matériaux thermoélectriques dont la hauteur $H_{NP}^{\alpha}$ est définie par la formule :

$$H_{NP}^{\alpha} \geq \frac{R}{\cos(\alpha)} \times \left( \exp\left( \frac{r_V \times 2\pi \times \lambda_{sub} \times e}{m \times S_{np} \times \Phi_{min}} \right) - 1 \right)$$

avec R le rayon du cercle circonscrit à la zone d'intérêt (4), $S_{np}$ le coefficient Seebeck différentiel des matériaux thermoélectriques desdits barreaux ($B_N$, $B_P$), $\lambda_{sub}$ la conductivité thermique du substrat (2), e l'épaisseur dudit substrat (2) et $\Phi_{min}$ la puissance thermique minimale à détecter, dissipée par le point chaud dans la zone d'intérêt (4).

13. Dispositif selon la revendication 3, **caractérisé en ce que** les barreaux ($B_N$, $B_P$) du thermocouple (TC) disposent de première et seconde extrémités, la première extrémité étant proximale de la zone d'intérêt (4) et la seconde extrémité étant distale de la zone d'intérêt (4), et **en ce que** des radiateurs miniatures (10-1) et/ou des micro-caloducs (10-2) sont disposés au niveau de la seconde extrémité des barreaux ($B_N$, $B_P$).

**Patentansprüche**

1. Elektronische Vorrichtung, umfassend:

   - ein Substrat (2), das mit einer Oberfläche (3) mit einem Bereich von Interesse (4) versehen ist, der ein oder mehrere aktive oder passive elektronische Bauelemente umfasst und dessen thermisches Verhalten zu überwachen ist,
   - ein System zur Erkennung von in dem Bereich von Interesse (4) befindlichen Hot Spots;

   **dadurch gekennzeichnet, dass** das Erkennungssystem umfasst:

   - wenigstens drei Wärmeflussmesser (5), die gegenüber einem Temperaturgradienten empfindlich und dazu bestimmt sind, Werte, die für einen durch einen Hot Spot (P) in dem Bereich von Interesse (4) erzeugten Wärmefluss repräsentativ sind, zu messen, wobei die Wärmeflussmesser (5) getrennt sind und auf der Oberfläche (3) des Substrats (2) außerhalb des Bereichs von Interesse (4) angeordnet sind; und
   - eine Recheneinheit, die dazu ausgelegt ist, die Werte der verschiedenen Wärmeflussmesser (5) zu analysieren und die Stelle eines Hot Spots (P) in dem Bereich von Interesse (4) zu bestimmen.

2. Vorrichtung nach Anspruch 1, **dadurch gekennzeichnet, dass** die Recheneinheit die Stelle eines Hot Spots (P) in dem Bereich von Interesse (4) durch Triangulation bestimmt.

3. Vorrichtung nach einem der Ansprüche 1 und 2, **dadurch gekennzeichnet, dass** jeder Wärmeflussmesser (5) wenigstens ein planares Thermoelement (TC) umfasst, das mit zwei Stäben ($B_N$, $B_P$) aus thermoelektrischen Materialien, welche zu der Ebene des Substrats (2) parallel angeordnet sind, versehen ist.

**4.** Vorrichtung nach Anspruch 3, **dadurch gekennzeichnet, dass** die Wärmeflussmesser (5) dazu ausgelegt sind, einen Wärmefluss, der sich in der Ebene des Substrats (2), auf dem die Thermoelemente (TC) ausgebildet sind, bewegt, zu erfassen.

**5.** Vorrichtung nach Anspruch 3, **dadurch gekennzeichnet, dass** der Wärmeflussmesser ($5_{TC}$) derart angeordnet ist, dass das Thermoelement (TC) ein zu dem Bereich von Interesse (4) proximales erstes Ende und ein von dem Bereich von Interesse (4) distales zweites Ende aufweist.

**6.** Vorrichtung nach einem der Ansprüche 1 bis 5, **dadurch gekennzeichnet, dass**:

- jeder Wärmeflussmesser (5) mit einer Erkennungsachse (D) ausgestattet ist, welche als die Gerade definiert ist, mit der die Richtung des Wärmewellenvektors ($U_T$) eines Spots (P) verschmolzen werden soll, um die besten Erkennungsgenauigkeiten und -empfindlichkeiten des Wärmeflussmessers (5) zu erhalten; und dass
- die Erkennungsachse (D) einen Ausrichtungswinkel $\alpha$ in Bezug auf eine durch das Isobaryzentrum (G) des Bereichs von Interesse (4) und den Wärmeflussmesser (5) verlaufende Gerade zwischen -$\pi/4$ und $\pi/4$ Radiant, einschließlich Grenzen, aufweist.

**7.** Vorrichtung nach Anspruch 6, **dadurch gekennzeichnet, dass** das System zur Erkennung von Hot Spots Mittel umfasst, um die Wärmeflussmesser (5) in Rotation zu versetzen, um den Ausrichtungswinkel $\alpha$ der Erkennungsachse (D) einzustellen.

**8.** Vorrichtung nach einem der Ansprüche 1 bis 7, **dadurch gekennzeichnet, dass** die Wärmeflussmesser (5) in im Wesentlichen gleichen Abständen von dem Isobaryzentrum (G) des Bereichs von Interesse (4) gelegen sind.

**9.** Vorrichtung nach einem der Ansprüche 1 bis 8, **dadurch gekennzeichnet, dass** die Wärmeflussmesser (5) in Form eines Polygons (A') angeordnet sind, von dem jede Spitze einem Wärmeflussmesser (5) zugeordnet ist, wobei das Polygon (A') regelmäßig ist und in einen Kreis (C), dessen Mittelpunkt mit dem Isobaryzentrum (G) des Bereichs von Interesse (4) zusammenfällt, einbeschrieben werden kann.

**10.** Vorrichtung nach einem der Ansprüche 1 bis 7, **dadurch gekennzeichnet, dass** die Wärmeflussmesser (5) entlang von zwei senkrechten Achsen, die zwei benachbarte Seiten eines Rechtecks bilden, in dem der Bereich von Interesse (4) enthalten ist, verteilt sind.

**11.** Vorrichtung nach einem der Ansprüche 1 bis 9, **dadurch gekennzeichnet, dass** das System zur Erkennung von Hot Spots in dem Bereich von Interesse (4) ein System zur Erfassung der elektrischen Signale der Wärmeflussmesser ($5_{TC}$) mit Messauflösung $r_V$ umfasst und dass jeder Wärmeflussmesser ($5_{TC}$) eine Anzahl m von Thermoelementen umfasst, wobei jedes Thermoelement mit zwei Stäben ($B_N$, $B_P$) aus thermoelektrischen Materialien versehen ist, deren Höhe $H_{NP}$ durch die Formel definiert ist:

$$H_{NP} \geq R \times \left( \exp\left( \frac{r_V \times 2\pi \times \lambda_{sub} \times e}{m \times S_{np} \times \Phi_{min}} \right) - 1 \right)$$

wobei R der Radius des dem Bereich von Interesse (4) umbeschriebenen Kreises ist, $S_{np}$ der differentielle Seebeck-Koeffizient der thermoelektrischen Materialien der Stäbe ($B_N$, $B_P$) ist, $\lambda_{sub}$ die Wärmeleitfähigkeit des Substrats (2) ist, e die Dicke des Substrats (2) ist und $\Phi_{min}$ die zu erkennende minimale Wärmeleistung, welche durch den Hot Spot in dem Bereich von Interesse (4) abgeführt wird, ist.

**12.** Vorrichtung nach Anspruch 6, **dadurch gekennzeichnet, dass** das System zur Erkennung von Hot Spots in dem Bereich von Interesse (4) ein System zur Erfassung der elektrischen Signale der Wärmeflussmesser (5) mit Messauflösung $r_V$ umfasst und dass jeder Wärmeflussmesser (5) eine Anzahl m von Thermoelementen umfasst, wobei jedes Thermoelement mit zwei Stäben ($B_N$, $B_P$) aus thermoelektrischen Materialien versehen ist, deren Höhe $H_{NP}^{\alpha}$ durch die Formel definiert ist:

$$H_{NP}^{\alpha} \;\geq\; \frac{R}{\cos(\alpha)} \times \left( \exp\left( \frac{r_V \times 2\pi \times \lambda_{sub} \times e}{m \times S_{np} \times \Phi_{\min}} \right) - 1 \right)$$

wobei R der Radius des dem Bereich von Interesse (4) umbeschriebenen Kreises ist, $S_{np}$ der differentielle Seebeck-Koeffizient der thermoelektrischen Materialien der Stäbe ($B_N$, $B_P$) ist, $\lambda_{sub}$ die Wärmeleitfähigkeit des Substrats (2) ist, e die Dicke des Substrats (2) ist und $\Phi_{\min}$ die zu erkennende minimale Wärmeleistung, welche durch den Hot Spot in dem Bereich von Interesse (4) abgeführt wird, ist.

13. Vorrichtung nach Anspruch 3, **dadurch gekennzeichnet, dass** die Stäbe ($B_N$, $B_P$) des Thermoelements (TC) über ein erstes und ein zweites Ende verfügen, wobei das erste Ende zu dem Bereich von Interesse (4) proximal ist und das zweite Ende von dem Bereich von Interesse (4) distal ist, und dass Miniaturkühler (10-1) und/oder Mikrowärmerohre (10-2) im Bereich des zweiten Endes der Stäbe ($B_N$, $B_P$) angeordnet sind.

## Claims

1. Electronic device comprising:

   - a substrate (2) provided with a surface (3) comprising a region of interest (4) comprising one or several active or passive electronic components, the thermal behavior of which is to be monitored;
   - a system for detecting hot spots located in the region of interest (4);

   **characterized in that** the detection system comprises:

   - at least three heat flow meters (5) sensitive to a temperature gradient and intended to measure values representative of a heat flow generated by a hot spot (P) in the region of interest (4), the heat flow meters (5) being separate and arranged on the surface (3) of the substrate (2) outside of the region of interest (4); and
   - a calculation unit configured to analyze the values of the different heat flow meters (5), and to determine the location of a hot spot (P) in the region of interest (4).

2. Device according to claim 1, **characterized in that** the calculation unit determines the location of a hot spot (P) in the region of interest (4) by triangulation.

3. Device according to any of claims 1 and 2, **characterized in that** each heat flow meter (5) comprises at least one planar thermocouple (TC) provided with two legs ($B_N$, $B_P$) made of thermoelectric materials arranged parallel to the plane of the substrate (2).

4. Device according to claim 3, **characterized in that** the heat flow meters (5) are configured to detect a heat flow displacing in the plane of the substrate (2) having the thermocouples (TC) formed thereon.

5. Device according to claim 3, **characterized in that** the heat flow meter ($5_{TC}$) is arranged so that the thermocouple (TC) comprises a first end proximal to the region of interest (4), and a second end distal to the region of interest (4).

6. Device according to any of claims 1 to 5, **characterized in that**:

   - each heat flow meter (5) is provided with a detection axis (D) defined as being the straight line with which the direction of the heat wave vector ($U_T$) of a spot (P) should be confounded to obtain the best accuracies and sensitivities of detection by the heat flow meter (5); and **in that**
   - the detection axis (D) has a direction angle $\alpha$ relative to a straight line running through the center of gravity (G) of the region of interest (4) and the heat flow meter (5) in the range from $-\pi/4$ to $\pi/4$ radian, inclusive.

7. Device according to claim 6, **characterized in that** the hot spot detection system comprises means for rotating the heat flow meters (5) to adjust direction angle $\alpha$ of the detection axis (D).

8. Device according to any of claims 1 to 7, **characterized in that** the heat flow meters (5) are located at substantially equal distances from the center of gravity (G) of the region of interest (4).

9.  Device according to any of claims 1 to 8, **characterized in that** the heat flow meters (5) are arranged in the form of a polygon (A') having each of its summits associated with a heat flow meter (5), the polygon (A') being regular and likely to be inscribed within a circle (C) having its center coinciding with the center of gravity (G) of the region of interest (4).

10. Device according to any of claims 1 to 7, **characterized in that** the heat flow meters (5) are distributed along two perpendicular axes forming two adjacent sides of a rectangle having the region of interest (4) contained therein.

11. Device according to any of claims 1 to 9, **characterized in that** the system for detecting hot spots in the region of interest (4) comprises a system for acquiring electric signals from the heat flow meters ($5_{TC}$) with a measurement resolution $r_V$, and **in that** each heat flow meter ($5_{TC}$) comprises a number m of thermocouples, each thermocouple being provided with two legs ($B_N$, $B_P$) made of thermoelectric materials having their height $H_{NP}$ defined by formula:

$$ H_{NP} \geq R \times \left( \exp\left( \frac{r_V \times 2\pi \times \lambda_{sub} \times e}{m \times S_{np} \times \Phi_{\min}} \right) - 1 \right) $$

with R being the radius of the circle circumscribed in the region of interest (4), $S_{np}$ the differential Seebeck coefficient of the thermoelectric materials of said legs ($B_N$, $B_P$), $\lambda_{sub}$ the heat conductivity of the substrate (2), e the thickness of said substrate (2), and $\Phi_{\min}$ the minimum thermal power to be detected, dissipated by the hot spot in the region of interest (4).

12. Device according to claim 6, **characterized in that** the system for detecting hot spots in the region of interest (4) comprises a system for acquiring electric signals from the heat flow meters (5) with a measurement resolution $r_V$, and **in that** each heat flow meter (5) comprises a number m of thermocouples, each thermocouple being provided with two legs ($B_N$, $B_P$) made of thermoelectric materials having their height $H_{NP}^{\alpha}$ defined by formula:

$$ H_{NP}^{\alpha} \geq \frac{R}{\cos(\alpha)} \times \left( \exp\left( \frac{r_V \times 2\pi \times \lambda_{sub} \times e}{m \times S_{np} \times \Phi_{\min}} \right) - 1 \right) $$

with R being the radius of the circle circumscribed in the region of interest (4), $S_{np}$ the differential Seebeck coefficient of the thermoelectric materials of said legs ($B_N$, $B_P$), $\lambda_{sub}$ the heat conductivity of the substrate (2), e the thickness of said substrate (2), and $\Phi_{\min}$ the minimum thermal power to be detected, dissipated by the hot spot in the region of interest (4).

13. Device according to claim 3, **characterized in that** the legs ($B_N$, $B_P$) of the thermocouple (TC) have first and second ends, the first end being proximal to the region of interest (4) and the second end being distal to the region of interest (4), and **in that** miniature radiators (10-1) and/or micro heat pipes (10-2) are arranged at the second end of the legs ($B_N$, $B_P$).

**Figure 1**

**Figure 2**

**Figure 3**

**Figure 4**

Figure 5

Figure 6

**Figure 7**

**Figure 8**

**Figure 9**

**Figure 10**

**EP 2 740 152 B1**

## RÉFÉRENCES CITÉES DANS LA DESCRIPTION

### Documents brevets cités dans la description

- US 20070296071 A
- US 2009288425 A
- US 2009312887 A